# EUROPÄISCHE PATENTSCHRIFT

(11) **EP 1 270 167 B1**
(45) Veröffentlichungstag und Bekanntmachung des Hinweises auf die Patenterteilung: **28.03.2007**
(21) Anmeldenummer: 02009637.6
(22) Anmeldetag: 27.04.2002
(51) Int. Cl.: B29C 45/14, H05K 5/00, H05K 1/02

(54) **Verfahren zur Herstellung eines Gerätegehäuses**
Method for producing an apparatus housing
Procédé pour fabriquer un boîtier d'appareillage

(30) Priorität: 29.06.2001 DE 10131601
(43) Veröffentlichungstag der Anmeldung: 02.01.2003
(73) Patentinhaber: Gebr. Swoboda GmbH, 87487 Wiggensbach (DE)
(72) Erfinder: Hackl, Johannes, 87487 Ermengerst (DE)
(74) Vertreter: Kloiber, Thomas

(56) Entgegenhaltungen:
- EP-A- 0 521 343
- DE-A- 3 916 899
- DE-A- 4 224 720
- DE-A- 19 625 756
- US-A- 4 861 251
- US-A- 4 879 630

## Beschreibung

Die Erfindung betrifft ein Verfahren zur Herstellung von Gehäuseteilen aus Kunststoff, die mit flexiblen Leiterbahnfolien zur Verbindung elektrischer oder elektronischer Bauteile versehen sind.

Bei der Herstellung von elektrischen Geräten müssen die einzelnen elektrischen oder elektronischen Bauteile elektrisch miteinander verbunden werden. Um den damit verbundenen Fertigungsaufwand zu reduzieren, ist es bekannt, elektrische Leitungen als Stanzteile auszuführen, die bei der Herstellung von Kunststoffgehäusen in diese integriert werden. Beim nachfolgenden Einbau elektronischer oder elektrischer Bauteile wird die elektrische Verbindung zwischen diesen ohne zusätzlichen Aufwand hergestellt. Die Ausführung der elektrischen Verbindungen als Stanzteile hat jedoch den Nachteil, dass eventuell später notwendige Änderungen der elektrischen Verbindungen mit Änderungen der relativ kostspieligen Stanzwerkzeuge verbunden und somit aufwendig und unrentabel sind.

Es ist auch bekannt, elektrische Drähte oder starre Leiterbahnen durch flexible Leiterbahnfolien zu ersetzen, die bei der Herstellung des Kunststoffgehäuses in dieses integriert werden, indem die Leiterbahn während des Spritzgußverfahrens hinterspritzt wird. Die hinterspritzte Leiterbahnfolie ist somit im Kunststoffgehäuse fixiert und stellt nach Einsetzen der elektrischen oder elektronischen Bauteile die elektrische Verbindung zwischen diesen her. Dieses Verfahren funktioniert solange zufriedenstellend, als die flexiblen Leiterbahnfolien tatsächlich nur Leiterbahnen enthalten. Zunehmend wird es aber erforderlich, die flexiblen Leiterbahnfolien mit weiteren elektronischen Bauteilen zu bestücken.

Das nachträgliche Bestücken der bereits mit dem Kunststoffgehäuse verbundenen Leiterbahnfolien hat jedoch den Nachteil, dass das Verlöten der elektronischen Bauteile auf der Leiterbahnfolie relativ aufwendig und kostenintensiv ist, weil die Lotpaste durch Dispensen Punkt für Punkt aufgetragen werden muss.

Die Bestückung der Leiterbahnfolie außerhalb des Kunststoffgehäuses kann relativ kostengünstig geschehen, weil die Lotpaste für alle Lötpunkte in einem einzigen Arbeitsgang fast gleichzeitig durch Rakeln der Lotpaste durch eine aufgelegte Maske hindurch auf die Leiterbahnfolie aufgebracht werden kann. Allerdings muss dann die bereits mit elektronischen Bauteilen bestückte Leiterbahnfolie bei der Herstellung des Kunststoffgehäuses mit unter hohem Druck stehendem heißen Kunststoff hinterspritzt werden. Dabei können die empfindlichen elektronischen Bauteile entweder durch Überhitzung oder durch den mechanischen Druck zerstört werden.

Aufgabe der Erfindung ist es, ein Verfahren zur Herstellung von Gerätegehäuseteilen aus Kunststoff anzugeben, welches das Hinterspritzen von mit elektronischen Bauteilen versehenen Leiterbahnfolien ermöglicht.

Diese Aufgabe wird erfindungsgemäß durch ein Verfahren gelöst, das die folgenden Verfahrensschritte umfaßt:
- Bestücken einer Seite der Leiterbahnfolie mit elektronischen Bauteilen sowie Anbringen von mindestens einer einen Teilbereich der Leiterbahnfolie abdeckenden Stützplatte auf der anderen Seite der Leiterbahnfolie, wobei die Stützplatte mindestens einen mit elektronischen Bauteilen bestückten Bereich der Leiterbahnfolie von der Rückseite her abstützt und versteift;
- Einbringen der mit mindestens einer Stützplatte versehenen Leiterbahnfolie in ein Spritzwerkzeug, welches zumindest eine Ausnehmung zur Aufnahme der auf der Leiterbahnfolie angebrachten Bauteile aufweist, in die die Bauteile hineinragen, wobei der Bereich der Ausnehmung von der Stützplatte überdeckt wird;
- Schließen des Spritzwerkzeugs und Einspritzen von Kunststoff, wobei die Leiterbahnfolie zumindest auf ihrer mit der Stützplatte fest verbundenen Seite vom Kunststoff umspritzt oder hinterspritzt wird und die genannte Ausnehmung im wesentlichen frei von Kunststoff bleibt.

Das erfindungsgemäße Herstellungsverfahren hat den Vorteil, dass die elektronischen Bauteile auf die Leiterbahnfolie mit kostengünstigen Standardverfahren aufgebracht werden und die mit elektronischen Bauteilen bestückte Leiterbahnfolie anschließend dennoch während des Spritzgußverfahrens mit dem Gerätegehäuse bzw. dem Gerätegehäuseteil verbunden werden kann, ohne die empfindlichen elektronischen Bauteile dabei zu zerstören.

Der mit den elektronischen Bauteilen versehene Bereich der Leiterbahnfolie deckt sich während des Spritzgusses mit einer Ausnehmung des Spritzwerkzeugs, wobei die Bauteile in diese Ausnehmung hineinragen. Die Ausnehmung des Spitzwerkzeugs ist während des Spritzvorgangs zur Seite hin abgedichtet, so dass ein Hohlraum entsteht, in den während des Spritzgusses kein Kunststoff eindringen kann. Den "Deckel" zum Verschließen der Ausnehmung im Spritzwerkzeug wird dabei durch die auf der Rückseite der Leiterbahnfolie befestigte Stützplatte gebildet.

Die Stützplatte nimmt auch den Druck der eingespritzten Kunststoffmasse auf, so dass dieser nicht auf der Leiterbahnfolie mit den empfindlichen Bauteilen lastet. Ohne die Stützplatte könnten die Bauteile brechen oder die Leiterbahnen in der Leiterbahnfolie reißen.

Ein weiterer Vorteil des erfindungsgemäßen Verfahrens besteht darin, dass die Stützplatte auch die Wärme der heißen Kunststoffmasse im wesentlichen von den empfindlichen elektronischen Bauteilen fernhält, so dass diese nicht unzulässig erhitzt werden.

In einer besonderes kostengünstigen Ausführungsform des erfindungsgemäßen Verfahrens ist vorgesehen, dass die Bauteile auf der einen Seite der Leiterbahnfolie durch Löten befestigt werden, wobei vor der Bestückung der Bauteile eine Lotpaste mittels Rakeln durch eine auf die Leiterbahnfolie aufgelegte Maske aufgebracht wird.

Zur kostengünstigen und sicheren Befestigung der Stützplatte auf der Leiterbahnfolie wird empfohlen, die Stützplatte mit der Leiterbahnfolie zu verkleben

Die Verwendung einer Aluminiumplatte als Stützplatte hat den Vorteil, dass die durch die heiße Kunststoffmasse eingebrachte Wärme abgepuffert wird und somit Temperaturspitzen im Bereich der empfindlichen elektronischen Bauteile vermieden werden können. Außerdem übernimmt die Aluminiumplatte beim späteren Betrieb des Geräts die Aufgabe eines Kühlblechs zur Abführung der in den elektronischen Bauteilen entstehenden Wärme.

Die Kühlwirkung kann dadurch noch verbessert werden, dass die Stützplatte auf ihrer der Leiterbahnfolie abgewandten Seite mit Kühlrippen versehen ist.

Der Erfindungsgedanke ist im wesentlichen bereits in einer Leiterbahnfolie enthalten, die auf einer Seite mit elektronischen Bauteilen bestückt ist, und auf der anderen Seite mindestens eine einen Teilbereich der Leiterbahnfolie abdeckende Stützplatte aufweist, die mindestens einen mit elektronischen Bauteilen bestückten Bereich der Leiterbahnfolie versteift. Eine somit erfindungsgemäß ausgestaltete Leiterbahnfolie führt in Verbindung mit bekannten Herstellungsverfahren für Gerätegehäuseteile aus Kunststoff zu dem selben Ergebnis wie das erfindungsgemäße Verfahren nach einem der Ansprüche 1 bis 5.

Ausgestaltungsmerkmale der erfindungsgemäßen Leiterbahnfolie, deren Vorteile bereits weiter oben genannt sind, bestehen darin, dass die Stützplatte aufgeklebt ist, aus Aluminium besteht und Kühlrippen aufweist.

Zum Umfang der Erfindung gehört auch ein Gerätegehäuse oder ein Gerätegehäuseteil aus Kunststoff, das eine Leiterbahnfolie mit einer der oben genannten Merkmalskombinationen aufweist, bei dem die Leiterbahnfolie zumindest teilweise mit Kunststoff hinterspritzt oder umspritzt ist.

Ein Ausführungsbeispiel der Erfindung wird nachfolgend anhand der Zeichnungen näher erläutert. Die Figuren zeigen im Einzelnen:

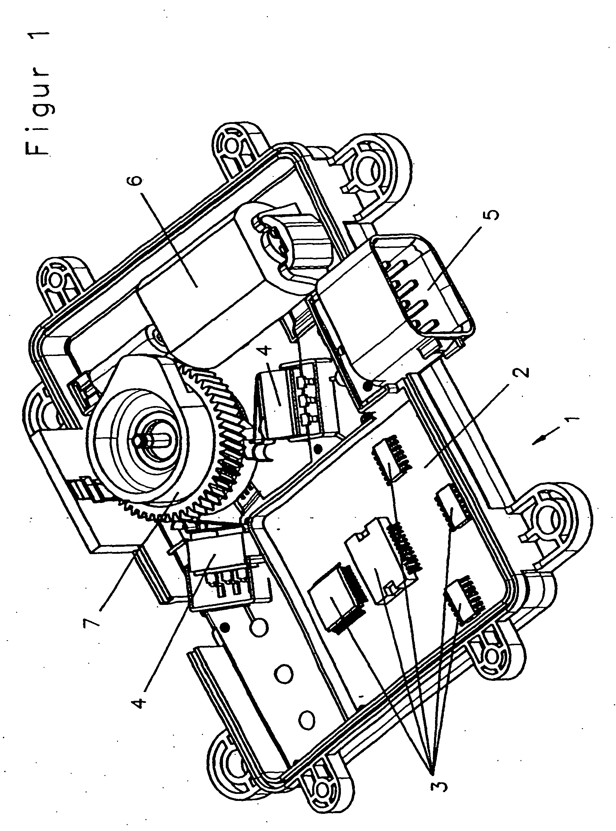

- Fig. 1: Eine perspektivische Ansicht eines erfindungsgemäßen Gerätegehäuseteils mit auf einer flexiblen Leiterbahnfolie angeordneten elektronischen Bauteilen;
- Fig. 2:: dasselbe Gehäuseteil im Schnitt mit einer schematischen Darstellung des Spritzwerkzeugs während des Spritzvorgangs.

In den Figuren erkennt man einen Gehäuseteil 1 einer Betätigungseinheit für eine Zentralverriegelungsanlage eines Kraftfahrzeugs. Das Gehäuseteil 1 besteht aus Kunststoff und ist im Spritzgußverfahren hergestellt worden. Dabei wurde eine Leiterbahnfolie 2, die mit elektronischen Bauteilen 3 bestückt ist, mit in das Gehäuseteil 1 eingegossen. Weiterhin sind in das Gehäuseteil 1 noch weitere elektrische Bauteile, beispielsweise Schalter 4, ein Stecker 5 und ein Elektromotor eingebaut worden. Des Weiteren ist ein Schneckengetriebe 7 zu erkennen.

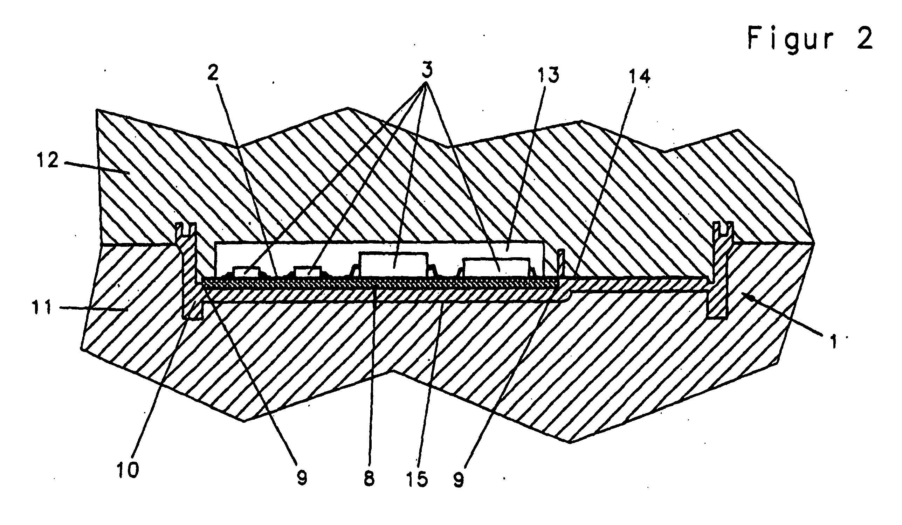

Wie man am besten in Fig. 2 erkennt, ist die Leiterbahnfolie 2 auf ihrer Rückseite mit einer Aluminiumplatte 8 versehen, die auf die Leiterbahnfolie 2 aufgeklebt ist. Die als Stützplatte dienende Aluminiumplatte 8 ist von ihren Schmalseiten 9 her von der Kunststoffmasse 10 des Gehäuseteils 1 umschlossen.

Zur Herstellung des Gehäuseteils 1 wird zunächst die flexible Leiterbahnfolie 2 mit Lotpaste versehen, indem auf die Leiterbahnfolie 2 eine nicht gezeigte Maske aufgelegt wird, durch welche hindurch die Lotpaste mittels Rakeln an den gewünschten Stellen aufgetragen wird. Anschließend werden die elektronischen Bauteile 3 aufgebracht und angelötet. Anschließend wird die Aluminiumplatte 8 als Stützplatte auf die Rückseite der Leiterbahnfolie 2 geklebt, wobei die seitliche Ausdehnung der Aluminiumplatte 8 den gesamten mit elektronischen Bauteilen 3 bestückten Bereich der Leiterbahnfolie 2 überstreicht und abstützen kann.

Die mit der Aluminiumplatte 8 und den elektronischen Bauteilen 3 versehene Leiterbahnfolie 2 wird nun in ein aus zwei Werkzeugteilen 11 und 12 bestehendes Spritzwerkzeug eingelegt. Im ersten Werkzeugteil 12 ist eine Ausnehmung 13 vorgesehen, die so angeordnet ist, dass die elektronischen Bauteile 3 in die Ausnehmung 13 hineinragen können. Dabei ist die Ausnehmung 13 auf die Lage der Aluminiumplatte 8 derart abgestimmt, dass die Ausnehmung 13 von der darunter liegenden Aluminiumplatte 8 vollständig abgedeckt werden kann.

Für den eigentlichen Spritzgußvorgang werden die beiden Werkzeugteile 11 und 12 aufeinander gelegt und das Spritzwerkzeug somit verschlossen. Dabei werden die Aluminiumplatte 8 und die darüberliegende Leiterbahnfolie an den die Ausnehmung 13 umgebenden Randbereich 14 des Werkzeugteils 12 angedrückt, so dass die Ausnehmung 13 fest verschlossen wird. Dies verhindert das Eindringen von heißer Kunststoffmasse in den von der Ausnehmung 13 und der Leiterbahnfolie 2 mit der Aluminiumplatte 8 gebildeten Hohlraum, und somit auch die Berührung der heißen Kunststoffmasse 10 mit den empfindlichen elektronischen Bauteilen 3. Beim eigentlichen Spritzvorgang wird die heiße Kunststoffmasse 10 in das Spritzwerkzeug 11, 12, eingepreßt, wobei die Leiterbahnfolie 2 teilweise an ihrer Rückseite umspritzt wird. Auch die Schmalseiten 9 der Aluminiumplatte 8 werden umspritzt. Die Erfindung umfaßt jedoch ebenfalls solche Ausführungsformen, bei denen die gesamte Rückseite 15 der Aluminiumplatte 8 mit Kunststoffmasse 10 umspritzt wird. Dabei stützt die Aluminiumplatte 8 in ihrer Funktion als Stützplatte den hohen Druck der eingespitzten Kunststoffmasse 10 ab, so dass dieser nicht schädigend auf die elektronischen Bauteile 3 einwirken kann. Nach dem Erstarren der Kunststoffmasse 10 kann das Gehäuseteil 1 aus dem Spritzwerkzeug 11, 12, entnommen werden.

Während des späteren Betriebs des fertigen Gerätes kann die in den elektronischen Bauteilen 3 entstehende Wärme durch die anliegende Aluminiumplatte 8 wirkungsvoll abgeführt werden. Im Kurzzeitbetrieb wird die Wärmekapazität der Aluminiumplatte 8 allein ausreichen, um die überschüssige Wärme aufzunehmen. Im Dauerbetrieb muss die Aluminiumplatte 8 als Kühlblech dienen. In diesem Fall empfiehlt sich eine Ausführungsform, bei der die Rückseite 15 der Aluminiumplatte 8 nicht von Kunststoffmasse 10 umspritzt ist. Die Wärme kann dann durch an der Rückseite 15 vorbeistreichende Luft wirkungsvoll abgeführt werden. Die Kühlwirkung kann dabei noch durch nicht gezeigte Kühlrippen auf der Rückseite 15 der Aluminiumplatte 8 verbessert werden.

### BEZUGSZEICHENLISTE

- 1: Gehäuseteil
- 2: Leiterbahnfolie
- 3: Elektronische Bauteile
- 4: Schalter
- 5: Stecker
- 6: Elektromotor
- 7: Schneckengetriebe
- 8: Aluminiumplatte/Stützplatte
- 9: Schmalseiten
- 10: Kunststoffmasse
- 11: Werkzeugteil
- 12: Werkzeugteil
- 13: Ausnehmung
- 14: Randbereich
- 15: Rückseite

## Patentansprüche

1. Verfahren zur Herstellung von Gerätegehäuseteilen (1) aus Kunststoff (10), die mit flexiblen Leiterbahnfolien (2) zur Verbindung elektrischer oder elektronischer Bauteile (3) versehen sind, umfassend die Verfahrensschritte:
- Bestücken einer Seite der Leiterbahnfolie (2) mit elektronischen Bauteilen (3) sowie Anbringen von mindestens einer einen Teilbereich der Leiterbahnfolie (2) abdeckenden Stützplatte (8) auf der anderen Seite der Leiterbahnfolie (2), wobei die Stützplatte (8) mindestens einen mit elektronischen Bauteilen (3) bestückten Bereich der Leiterbahnfolie (2) von der Rückseite her abstützt und versteift;
- Einbringen der mit mindestens einer Stützplatte (8) versehenen Leiterbahnfolie (2) in ein Spritzwerkzeug (11, 12), welches zumindest eine Ausnehmung (13) zur Aufnahme der auf der Leiterbahnfolie (2) angebrachten Bauteile (3) aufweist, in die die Bauteile (3) hineinragen, wobei der Bereich der Ausnehmung (13) von der Stützplatte (8) überdeckt wird;
- Schließen des Spritzwerkzeugs (11, 12) und Einspritzen von Kunststoff (10), wobei die Leiterbahnfolie (2) zumindest auf ihrer mit der Stützplatte (8) fest verbundenen Seite vom Kunststoff (10) mindestens teilweise umspritzt wird und die genannte Ausnehmung (13) im wesentlichen frei von Kunststoff (10) bleibt.

2. Verfahren nach Anspruch 1, **dadurch gekennzeichnet, dass** die Bauteile (3) auf der einen Seite der Leiterbahnfolie (2) durch Löten befestigt werden, wobei vor der Bestückung der Bauteile (3) eine Lotpaste mittels Rakeln durch eine auf die Leiterbahnfolie (2) aufgelegte Maske aufgebracht wird.

3. Verfahren nach Anspruch 1 oder 2, **dadurch gekennzeichnet, dass** die Stützplatte (8) auf die Leiterbahnfolie (2) aufgeklebt wird.

4. Verfahren nach einem der vorhergehenden Ansprüche, **gekennzeichnet durch** die Verwendung einer Aluminiumplatte (8) als Stützplatte.

5. Verfahren nach einem der vorhergehenden Ansprüche, **gekennzeichnet durch** die Verwendung einer Stützplatte (8), die auf ihrer der Leiterbahnfolie (2) abgewandten Seite mit Kühlrippen versehen ist.

6. Leiterbahnfolie, die auf einer Seite mit elektronischen Bauteilen (3) bestückt ist zur Verwendung in einem Verfahren nach einem der Ansprüche 1-5, **dadurch gekennzeichnet, dass** auf der anderen Seite der Leiterbahnfolie (2) mindestens eine einen Teilbereich der Leiterbahnfolie (2) abdeckende Stützplatte 8 befestigt ist, die mindestens einen mit elektronischen Bauteilen (3) bestückten Bereich der Leiterbahnfolie (2) versteift.

7. Leiterbahnfolie nach Anspruch 6, **dadurch gekennzeichnet, dass** die Stützplatte (8) aufgeklebt ist.

8. Leiterbahnfolie nach Anspruch 6 oder 7, **dadurch gekennzeichnet, dass** die Stützplatte (8) aus Aluminium besteht.

9. Leiterbahnfolie nach Anspruch 6, 7 oder 8, **dadurch gekennzeichnet, dass** die Stützplatte (8) Kühlrippen aufweist.

10. Gerätegehäuse oder Gerätegehäuseteil aus Kunststoff mit einer Leiterbahnfolie (2) nach einem der Ansprüche 6 bis 9, bei dem die Leiterbahnfolie (2) zumindest teilweise mit Kunststoff (10) hinterspritzt oder umspritzt ist.

## Claims

1. A method for the manufacture of equipment housing parts (1) made of plastic (10), which are fitted with flexible conducting track films (2) for connecting electrical or electronic components (3), comprising the method steps:
- population of one side of the conducting track film (2) with electronic components (3) and also the application of at least one support plate (8) covering a partial region of the conducting track film (2) on the other side of the conducting track film (2), wherein the support plate (8) supports and stiffens from the rear side at least one region of the conducting track film (2) populated with electronic components (3);
- insertion of the conducting track film (2) fitted with at least one support plate (8) into an injection moulding tool (11, 12) which has at least one recess (13) for the accommodation of the components applied to the conducting track film (2), into which the components (3) extend, wherein the region of the recess (13) is covered by the support plate (8);
- closing of the injection moulding tool (11, 12) and injection of plastic (10), wherein the conducting track film (2), at least on its side firmly connected with the support plate (8), is at least partially injection moulded with plastic (10) and the cited recess (13) remains essentially free of plastic (10).

2. The method according to claim 1, **characterised in that** the components (3) on the one side of the conducting track film (2) are attached by soldering, wherein before the population of the components (3) a solder paste is applied by means of scrapers through a mask laid onto the conducting track film (2).

3. The method according to claim 1 or 2, **characterised in that** the support plate (8) is attached with adhesive onto the conducting track film (2).

4. The method according to one of the previous claims, **characterised by** the use of an aluminium plate (8) as a support plate.

5. The method according to one of the previous claims, **characterised by** the use of a support plate (8), which on its side facing away from the conducting track film (2) is fitted with cooling ribs.

6. A conducting track film, which on one side is populated with electronic components (3) for use in a method according to one of the claims 1 to 5, **characterised in that** on the other side of the conducting track film (2) at least one support plate (8) is attached, covering a partial region of the conducting track film (2), which stiffens at least one region of the conducting track film (2) populated with electronic components (3).

7. The conducting track film according to claim 6, **characterised in that** the support plate (8) is attached with adhesive.

8. The conducting track film according to claim 6 or 7, **characterised in that** the support plate (8) is made of aluminium.

9. The conducting track film according to claim 6, 7 or 8, **characterised in that** the support plate (8) has cooling ribs.

10. An equipment housing or part of an equipment housing made of plastic with a conducting track film (2) according to one of the claims 6 to 9, in which the conducting track film (2) is at least partially in-mould laminated or injected moulded with plastic (10).

## Revendications

1. Procédé pour la fabrication de parties de boîtier d'appareil (1) en matière plastique (10), qui sont munies de feuilles flexibles de piste conductrice (2) pour la connexion de composants électriques (3) ou électroniques, comprenant les étapes suivantes :
- garnissage d'une face de la feuille de piste conductrice (2) de composants électroniques (3), ainsi que l'application d'au moins une plaque d'appui (8) recouvrant la zone partielle de la feuille de piste conductrice (2) sur l'autre face de la feuille de piste conductrice (2), la plaque d'appui (8) raidissant et soutenant au moins une zone garnie de composants électroniques (3), de la feuille de piste conductrice (2) depuis la face arrière,
- introduction de la feuille de piste conductrice (2) munie d'au moins une plaque d'appui (8) dans un outil de moulage par injection (11, 12) lequel présente au moins un évidement (13) pour le logement des composants appliqués sur la feuille de piste conductrice (2), dans lesquels s'engagent les composants (3), la zone de l'évidement (13) étant recouverte par la plaque d'appui (8);
- fermeture de l'outil de moulage par injection (11, 12) et injection de la matière plastique (10), la feuille de piste conductrice (2) étant enrobée du moins sur sa face reliée fixement à la plaque d'appui (8), au moins partiellement par la matière plastique (10) et ledit évidement (13) restant essentiellement épargné de matière plastique (10).

2. Procédé selon la revendication 1, **caractérisé en ce que** les composants (3) sont fixés par brasage sur une face de la feuille de piste conductrice (2), avant le garnissage des composants (3), une pâte à braser étant appliquée par raclage au moyen d'un masque placé sur la feuille de piste conductrice (2).

3. Procédé selon la revendication 1 ou 2, **caractérisé en ce que** la plaque d'appui (8) est collée sur la feuille de piste conductrice (2).

4. Procédé selon l'une des revendications précédentes, **caractérisé par** l'utilisation d'une plaque d'aluminium (8) en tant que plaque d'appui.

5. Procédé selon l'une des revendications précédentes, **caractérisé par** l'utilisation d'une plaque d'appui (8) qui est munie sur sa face détournée de la feuille de piste conductrice (2) de nervures de refroidissement.

6. Feuille de piste conductrice qui est garnie sur une face de composants électroniques (3) pour l'utilisation dans un procédé selon l'une des revendications 1 à 5, **caractérisée en ce que** il est fixé sur l'autre face de la feuille de piste conductrice (2) au moins une plaque d'appui (8) recouvrant une zone partielle de la feuille de piste conductrice (2) qui raidit au moins une zone de la feuille de piste conductrice (2), garnie de composants électroniques (3).

7. Feuille de piste conductrice selon la revendication 6, **caractérisée en ce que** la plaque d'appui (8) est collée.

8. Feuille de piste conductrice selon la revendication 6, ou 7, **caractérisée en ce que** la plaque d'appui (8) se compose d'aluminium.

9. Feuille de piste conductrice selon la revendication 6, 7 ou 8, **caractérisée en ce que** la plaque d'appui (8) présente des nervures de refroidissement.

10. Boîtier d'appareil ou partie de boîtier d'appareil en matière plastique avec une feuille de piste conductrice (2) selon l'une des revendications 6 à 9, où la feuille de piste conductrice (2) est injectée au moins partiellement par l'arrière ou enrobée par injection de matière plastique (10).
